# EUROPÄISCHE PATENTSCHRIFT

(11) **EP 3 943 277 B1**
(45) Veröffentlichungstag und Bekanntmachung des Hinweises auf die Patenterteilung: **17.04.2024**
(21) Anmeldenummer: 21186560.5
(22) Anmeldetag: 20.07.2021
(51) Int. Cl.: B29C 64/209, B29C 64/364, B29C 64/118, B29C 64/194, B33Y 10/00, B33Y 30/00, B33Y 40/10, B33Y 70/00

(54) **VORRICHTUNG UND VERFAHREN ZUR ADDITIVEN FERTIGUNG VON BAUTEILEN**
DEVICE AND METHOD FOR THE ADDITIVE MANUFACTURING OF COMPONENTS
PROCÉDÉ ET DISPOSITIF DE FABRICATION ADDITIVE DE COMPOSANTS

(30) Priorität: 20.07.2020 DE 102020209033
(43) Veröffentlichungstag der Anmeldung: 26.01.2022
(73) Patentinhaber: Fraunhofer-Gesellschaft zur Förderung der angewandten Forschung e.V., 80686 München (DE)
(72) Erfinder: Neubert, Thomas, 38108 Braunschweig (DE); Thomas, Michael, 38108 Braunschweig (DE); Abraham, Tim Gyung-Min, 38108 Braunschweig (DE); Lachmann, Kristina, 38108 Braunschweig (DE)
(74) Vertreter: Pfenning, Meinig & Partner mbB

(56) Entgegenhaltungen:
- EP-A2- 1 230 042
- US-A1- 2016 271 874
- US-A1- 2016 325 487

## Beschreibung

Die vorliegende Erfindung betrifft eine Vorrichtung zur additiven Fertigung von Bauteilen. Die Vorrichtung umfasst einen additiven Fertigungskopf mit einer Extrusionsdüse sowie eine um die Extrusionsdüse herum angeordnete oder in die Extrusionsdüse integrierte Plasmaquelle zur Erzeugung von Plasma. Zudem betrifft die vorliegende Erfindung auch ein Verfahren zur additiven Fertigung von Bauteilen. Im Verfahren wird mithilfe einer um eine Extrusionsdüse eines additiven Fertigungskopfes herum angeordneten oder in die Extrusionsdüse integrierten Plasmaquelle ein Plasma erzeugt. Ferner wird ein Material geschmolzen, durch die Extrusionsdüse gepresst und schichtweise abgelegt. Zudem erfolgt eine Behandlung mit dem Plasma, bei welcher eine Oberfläche, auf welcher das Material schichtweise abgelegt wird, vor dem Ablegen mit dem Plasma behandelt wird, und/oder das Material vor, während und/oder nach dem Ablegen mit dem Plasma behandelt wird. Das Verfahren ist mit allen seinen Merkmalen im Anspruch 5 definiert.

Verschiedene additive Fertigungsverfahren (Schmelzschichten, Lasersintern, Stereolithographie, Binder-Jetting, u.a.) sind aktueller Stand der Technik. Mit ihnen ist es möglich aus verschiedenen Materialien (z.B. Polymeren, Keramiken, Metallen) komplexe dreidimensionale Objekte herzustellen. Die Bauteile werden hierbei computergesteuert aus einzelnen Schichten aufgebaut. Wesentliche Vorteile dieser Techniken sind einerseits der hohe konstruktive Freiheitsgrad und zum anderen die geringen Kosten bei kleinen Stückzahlen. Generell nachteilig sind hingegen die langen Fertigungszeiten und die oft geringe Oberflächengüte (z.B. hohe Rauigkeit) der gedruckten Bauteile. Häufig weisen die Oberflächen der erhaltenen Bauteile allgemein auch noch nicht die gewünschten Eigenschaften auf.

Die aktuell am Weitesten eingesetzte additive Fertigungsmethode ist das sogenannte Schmelzschichten (engl. Fused Deposition Modeling (FDM)). Hierbei werden thermoplastische Polymere (z.B. PLA, ABS, PC, PET, PP, PEEK, PA, ...) thermisch aufgeschmolzen, durch eine Extrusionsdüse gepresst und dann ortsaufgelöst computergesteuert abgelegt.

Das Dokument US 2016/271874 A1 offenbart einen 3D-Druckkopf mit einem Plasmabehandler. Gaszufuhrkanäle zur Zufuhr van Arbeitsgas enden nahe an der Extrusionsdüse des 3D-Druckkopfes. Die Gaszufuhrkanäle können zur Zufuhr von Gas für eine plasmaunterstützte chemische Gasphasenabscheidung verwendet werden.

Ausgehend hiervon war es die Aufgabe der vorliegenden Erfindung eine Vorrichtung bzw. ein Verfahren zur additiven Fertigung von Bauteilen bereitzustellen, mit der auf schnelle Weise Bauteile hergestellt werden können, die eine erhöhte Oberflächengüte und/oder verbesserte Eigenschaften aufweisen.

Diese Aufgabe wird bezüglich einer Vorrichtung zur additiven Fertigung von Bauteilen mit den Merkmalen des Patentanspruchs 1 und bezüglich eines Verfahrens zur additiven Fertigung von Bauteilen mit den Merkmalen des Patentanspruchs 5 gelöst. Die abhängigen Patentansprüche stellen vorteilhafte Weiterbildungen dar.

Durch das erzeugte Plasma können verschiedene Prozesse ausgelöst werden, welche entweder vorteilig für den 3D-Druckprozess (d.h. die additive Fertigung) selbst sind (z.B. Reinigung der Oberfläche, auf der das Material mithilfe der Extrusionsdüse abgelegt wird) oder auch neue Funktionen zum gefertigten Bauteil hinzufügen bzw. die Eigenschaften des gefertigten Bauteils, insbesondere der Oberfläche des gefertigten Bauteils, verbessern. Hierdurch kann auch die Oberflächengüte der Oberfläche des Bauteils erhöht werden.

Mit dem durch die Plasmaquelle erzeugten Plasma können verschiedene Modifikationen an dem beim additiven Fertigungsprozess abzulegenden bzw. abgelegten Material vorgenommen werden, durch die die Eigenschaften des gefertigten Bauteils bzw. die Eigenschaften von dessen Oberfläche verbessert werden können. Beispielsweise ist es möglich Oberflächen von (z.B. organischen) Verunreinigungen zu reinigen. Zudem ist es mit dem erzeugten Plasma möglich Oberflächen zu oxidieren, zu reduzieren und/oder aufzurauen. Des Weiteren ist es im Falle von Polymeroberflächen möglich durch das Plasma Vernetzungen zu erzeugen. Auch ist es möglich durch das Plasma funktionale Gruppen auf Oberflächen zu erzeugen, welche großen Einfluss auf die Oberflächenenergie und das Adhäsionsverhalten (Verbesserung der Anhaftung von Farben, Lacken und Klebstoffen) hierauf haben. Durch zusätzlich verwendete schichtbildende Precursor lassen sich zudem (dünne) Schichten auf Oberflächen mit verschiedenen Funktionalitäten (z.B. hydrophob, hydrophil, antihaft, Migrationssperrschicht, etc.) in einem sogenannten Plasmaunterstützen Chemischen Gasphasenabscheidungsprozess (engl. PECVD) herstellen.

Dadurch, dass die Plasmaquelle um die Extrusionsdüse herum angeordnet oder in die Extrusionsdüse integriert ist, kann die Modifizierung des Materials bzw. der Oberfläche durch das Plasma direkt bei der additiven Herstellung des Bauteils erfolgen, sodass eine in-situ-(Oberflächen-)Modifizierung bei additiv gefertigten Bauteilen erfolgen kann. Hierbei kann das Material vor, während und/oder nach dem Ablegen mit dem Plasma behandelt werden. Da die Plasmabehandlung direkt bei der additiven Herstellung erfolgt, kann auf zeitaufwändige Nachbehandlung des hergestellten Bauteils mit einer weiteren Vorrichtung in einem separaten Verfahren verzichtet werden. Auf diese Weise wird trotz der Plasmabehandlung eine vergleichsweise schnelle Herstellung des additiv gefertigten Bauteils erreicht.

Mit der erfindungsgemäßen Vorrichtung wird somit eine Vorrichtung zur additiven Fertigung von Bauteilen bereitgestellt, mit der Bauteile auf vergleichsweise schnelle Weise hergestellt werden können, die eine erhöhte Oberflächengüte und/oder verbesserte Eigenschaften aufweisen.

Mit der vorgeschlagenen Plasmaquelle ist es möglich reinigend, funktionalisierend und beschichtend zu arbeiten. Für das Abscheiden von funktionalen Beschichtungen können verschiedene schichtbildende Präkursoren (z.B. Hexamethyldisiloxan, Tetramethyldisiloxan, Hexamethylcyclotrisiloxan, Octofluorocyclobutan, Aminopropyltrimethoxysilan, Aminopropyltriethoxysilan, Glycidyloxypropyltrimethoxysilan, Mercaptopropyltrimethoxysilan, Isocyanatopropyltrimethoxysilan, Glycidylmethacrylat, Oxazolinen, Maleinsäureanhydrid, sowie Mischungen hiervon) entweder direkt dem Prozessgas oder über eine separate Leitung der Beschichtungszone zugeführt werden. Auch ist es möglich die Plasmaquelle mit unterschiedlich-gepulster elektrischer Leistungszufuhr (kHz bis MHz-Bereich, verschiedene Abtastverhältnisse / duty-cycle) zu betreiben, um die Präkursoren strukturerhaltend abzuscheiden.

Eine bevorzugte Ausführungsform der erfindungsgemäßen Vorrichtung zeichnet sich dadurch aus, dass die Plasmaquelle eine Prozessgaszuleitung und eine Hochspannungselektrode umfasst. Die Erzeugung des Plasmas kann somit innerhalb der Vorrichtung auf einfache Weise dadurch erfolgen, dass ein durch die Prozessgaszuleitung zugeführtes Prozessgas durch ein von der Hochspannungselektrode erzeugtes elektrisches Feld ionisiert wird. Vorzugsweise kann die Plasmaquelle dazu geeignet sein, das Plasma durch eine Gasentladung zu erzeugen, welche vorzugsweise ausgewählt ist aus der Gruppe bestehend aus dielektrisch behinderten Entladungen, Koronaentladungen, Bogenentladungen, durch Mikrowellen angeregte Entladungen, durch Radiofrequenz angeregte Entladungen, und Kombinationen hiervon.

Gemäß einer weiteren bevorzugten Ausführungsform ist die Plasmaquelle um die Extrusionsdüse herum angeordnet und umfasst eine auf einer (äußeren) Oberfläche der Plasmaquelle angeordnete und mit der Prozessgaszuleitung verbundene Mulde als Plasmaerzeugungsbereich, wobei die Mulde und die Hochspannungselektrode um die Extrusionsdüse herum und konzentrisch zueinander angeordnet sind. In dieser Anordnung kann zunächst das Prozessgas über die Prozessgaszuleitung in die Mulde geleitet werden, wobei in der Mulde dann mithilfe der Hochspannungselektrode das Plasma erzeugt wird. Anschließend kann das in der Mulde erzeugte Plasma mit der Oberfläche, auf welcher das Material schichtweise abgelegt wird, oder mit dem Material selbst in Kontakt kommen. Durch die Anordnung der Mulde auf einer Oberfläche der Plasmaquelle um die Extrusionsdüse herum und konzentrisch zur Hochspannungselektrode kann folglich auf einfache Weise erreicht werden, dass das Plasma in der Nähe des durch die Extrusionsdüse abgelegten Materials oder der Oberfläche, auf welcher das Material abgelegt werden soll, erzeugt wird und dann problemlos mit dem durch die Extrusionsdüse abgelegten Material oder der Oberfläche, auf welcher das Material abgelegt werden soll, in Kontakt kommen kann. Zudem kann durch die Anordnung erreicht werden, dass das Plasma gleichmäßig im Bereich um die Extrusionsdüse herum verteilt wird, sodass das frisch abgelegte Material (unabhängig von der Bewegungsrichtung der Extrusionsdüse) sehr schnell mit dem Plasma in Kontakt kommt.

Bei dieser Anordnung ist besonders vorteilhaft, dass die Mulde an einen Bereich grenzen kann, an dem das Material durch die Extrusionsdüse abgelegt wird bzw. wurde. Somit kann auf einfache Weise eine Zuführung des Plasmas zum mit der Extrusionsdüse frisch abgelegten Material und/oder der Oberfläche, auf welcher das Material abgelegt werden soll, erreicht werden, sodass eine problemlose Modifizierung des abgelegten Materials bzw. von dessen Oberfläche und/oder der Oberfläche, auf welcher das Material abgelegt werden soll, durch das Plasma ermöglicht wird.

Bei der mit der Prozessgaszuleitung verbundenen Mulde kann es sich um eine Vertiefung innerhalb einer äußeren Oberfläche der Plasmaquelle handeln. Die (äußere) Oberfläche der Plasmaquelle, auf welcher die Mulde angeordnet ist, kann in dieselbe Richtung weisen wie die Öffnung der Extrusionsdüse, durch die das abzulegende Material die Extrusionsdüse verlässt. Vorzugsweise ist die mit der Prozessgas-Zuleitung verbundene Mulde kreisförmig um die Extrusionsdüse herum angeordnet. Vorzugsweise ist die mit der Prozessgaszuleitung verbundene Mulde kreisförmig so um die Extrusionsdüse herum angeordnet, dass die Extrusionsdüse im Zentrum liegt.

Die Plasmaquelle kann an der Extrusionsdüse anliegen. Die Plasmaquelle kann zylinderförmig um die Extrusionsdüse herum angeordnet sein, vorzugsweise zylinderförmig um die Extrusionsdüse herum anliegen.

Unter einem Plasmaerzeugungsbereich im Sinne der vorliegenden Erfindung kann der Bereich verstanden werden, in dem (z.B. mithilfe des Prozessgas und der Hochspannungselektrode) Plasma erzeugt wird bzw. werden kann.

Eine weitere bevorzugte Ausführungsform ist dadurch gekennzeichnet, dass die Plasmaquelle in die Extrusionsdüse integriert ist, wobei die Prozessgaszuleitung mit einem Kanal der Extrusionsdüse zum Hindurchpressen von geschmolzenem Material verbunden ist, wobei die Hochspannungselektrode um einen Plasmaerzeugungsbereich des Kanals der Extrusionsdüse herum angeordnet ist, und wobei sich die Verbindung zwischen der Prozessgaszuleitung und dem Kanal der Extrusionsdüse in dem Plasmaerzeugungsbereich und/oder in Pressrichtung des Materials vor dem Plasmaerzeugungsbereich befindet. In dieser Anordnung kann zunächst das Prozessgas über die Prozessgaszuleitung dem sich in der Extrusionsdüse befindlichen Material zugeführt werden und anschließend innerhalb der Extrusionsdüse mithilfe der Hochspannungselektrode das Plasma erzeugt werden. Somit kann das Plasma noch in der Extrusionsdüse mit dem noch nicht abgelegten Material in Kontakt kommen. Zudem kann das Plasma mit dem Material aus der Extrusionsdüse entweichen und dann auch mit dem bereits abgelegten Material in Kontakt kommen. So wird auf einfache Weise eine Modifizierung des Materials durch das Plasma ermöglicht. Durch diese spezielle Ausführung kann somit auf einfach Weise erreicht werden, dass das Plasma in unmittelbarer Nähe zum Material erzeugt wird und daher problemlos mit dem durch die Extrusionsdüse abzulegenden bzw. abgelegten Material oder der Oberfläche, auf welcher das Material abgelegt werden soll, in Kontakt kommen kann. Zudem kann auch durch diese Anordnung erreicht werden, dass das Plasma gleichmäßig im Bereich um die Extrusionsdüse herum verteilt wird, sodass das frisch abgelegte Material (unabhängig von der Bewegungsrichtung der Extrusionsdüse) sehr schnell mit dem Plasma in Kontakt kommt.

Die erfindungsgemäße Vorrichtung zeichnet sich dadurch aus, dass die Plasmaquelle eine Precursorgaszuleitung umfasst, wobei die Precursorgaszuleitung mit einer auf einer Oberfläche der Plasmaquelle angeordneten Mulde verbunden ist, die um die Extrusionsdüse herum angeordnet ist. Die Oberfläche der Plasmaquelle, auf welcher die Mulde angeordnet ist, kann in dieselbe Richtung weisen wie die Öffnung der Extrusionsdüse, durch die das abzulegende Material die Extrusionsdüse verlässt. Vorzugsweise ist die mit der Precursorgaszuleitung verbundene Mulde kreisförmig um die Extrusionsdüse herum angeordnet. Vorzugsweise ist die mit der Precursorgaszuleitung verbundene Mulde kreisförmig so um die Extrusionsdüse herum angeordnet, dass die Extrusionsdüse im Zentrum liegt.

Vorzugsweise handelt es sich bei der mit der Precursorgaszuleitung verbundenen Mulde nicht um die mit der Prozessgas-Zuleitung verbundene Mulde. Alternativ kann es sich bei der mit der Precursorgaszuleitung verbundenen Mulde aber auch um die mit der Prozessgas-Zuleitung verbundene Mulde handeln. Vorzugsweise ist die mit der Precursorgaszuleitung verbundene Mulde auf der gleichen (äußeren) Oberfläche der Plasmaquelle angeordnet wie die mit der Prozessgaszuleitung verbundene Mulde. Vorzugsweise hat die mit der Precursorgaszuleitung verbundene Mulde einen geringeren Abstand zur Extrusionsdüse als die die mit der Prozessgaszuleitung verbundene Mulde. Vorzugsweise sind die mit der Precursorgaszuleitung verbundene Mulde und/oder die mit der Prozessgaszuleitung verbundene Mulde kreisförmig um die Extrusionsdüse herum angeordnet. Vorzugsweise sind die mit der Precursorgaszuleitung verbundene Mulde und/oder die mit der Prozessgaszuleitung verbundene Mulde kreisförmig so um die Extrusionsdüse herum angeordnet, dass die Extrusionsdüse im Zentrum liegt.

Eine besonders bevorzugte Ausführungsform der erfindungsgemäßen Vorrichtung ist dadurch gekennzeichnet, dass die Plasmaquelle um die Extrusionsdüse herum angeordnet ist und eine auf einer (äußeren) Oberfläche der Plasmaquelle angeordnete und mit der Prozessgaszuleitung verbundene erste Mulde als Plasmaerzeugungsbereich umfasst, wobei die erste Mulde und die Hochspannungselektrode um die Extrusionsdüse herum und konzentrisch zueinander angeordnet sind und wobei die Mulde der Precursorgaszuleitung eine zweite Mulde ist. Die (äußere) Oberfläche der Plasmaquelle, auf welcher die erste Mulde und die zweite Mulde angeordnet sind, kann in dieselbe Richtung weisen wie die Öffnung der Extrusionsdüse, durch die das abzulegende Material die Extrusionsdüse verlässt. Vorzugsweise hat die zweite Mulde einen geringeren Abstand zur Extrusionsdüse als die erste Mulde. Vorzugsweise sind die erste Mulde und/oder die zweite Mulde kreisförmig um die Extrusionsdüse herum angeordnet. Vorzugsweise sind die erste Mulde und/oder die zweite Mulde kreisförmig so um die Extrusionsdüse herum angeordnet, dass die Extrusionsdüse im Zentrum liegt.

Vorzugweise umfasst die Vorrichtung einen Heizblock zum Schmelzen von Material, aus welchem die Bauteile gefertigt werden sollen.

Die erfindungsgemäße Vorrichtung kann zusätzlich eine geerdete Elektrode und/oder einen Hochspannungsgenerator umfassen. Die geerdete Elektrode ist vorzugsweise um die Extrusionsdüse herum angeordnet und/oder konzentrisch zur Hochspannungselektrode angeordnet.

Vorzugsweise sind die Hochspannungselektrode und/oder die geerdete Elektrode elektrisch isoliert.

Vorzugweise sind die Hochspannungselektrode und die geerdete Elektrode dazu geeignet, dass zwischen ihnen ein elektrisches (Wechsel-)Feld mit einer Potentialdifferenz > 1kV (bzw. > 1 kHz) erzeugt werden kann.

Vorzugsweise handelt es sich bei der Hochspannungselektrode und/oder der geerdete Elektrode um eine kreisförmige Elektrode bzw. um kreisförmige Elektroden.

Bei der erfindungsgemäßen Vorrichtung kann es sich um einen 3D-Drucker, vorzugsweise um einen FDM-3D-Drucker, handeln.

Die Plasmaquelle und/oder die Extrusionsdüse umfassen vorzugsweise einen Grundkörper, der aus einem temperaturstabilen und elektrisch nicht leitfähigen Material, besonders bevorzugt Keramik oder Glas, besteht.

Erfindungsgemäß wird zudem ein Verfahren angegeben, welches im Anspruch 5 definiert ist.

In Schritt a) wird mithilfe einer Plasmaquelle ein Plasma erzeugt. Die Plasmaquelle ist um eine Extrusionsdüse eines additiven Fertigungskopfes herum angeordnet oder in die Extrusionsdüse integriert.

In Schritt b) wird ein Material, aus dem das gewünschte Bauteil gefertigt werden soll, zunächst geschmolzen, dann durch die Extrusionsdüse gepresst und schließlich schichtweise abgelegt. Schritt b) kann vor, während und/oder nach Schritt a) durchgeführt werden. Das Schmelzen des Materials kann beispielsweise mithilfe eines Heizblocks erfolgen.

In Schritt c) erfolgt eine Behandlung mit dem Plasma. In einer ersten Variante der Behandlung mit dem Plasma wird eine Oberfläche, auf welcher das Material in Schritt b) schichtweise abgelegt wird, vor dem Ablegen in Schritt b) mit dem Plasma behandelt. Beispielsweise kann hierbei die Oberfläche vor dem Ablegen gereinigt werden. Hierdurch können Verunreinigungen auf der Oberfläche des hergestellten Bauteils verringert oder vermieden werden, wodurch sich die Oberflächengüte und/oder (Oberflächen-)Eigenschaften des Bauteils verbessern. In einer zweiten Variante der Behandlung mit dem Plasma wird das Material vor, während und/oder nach dem Ablegen in Schritt b) mit dem Plasma behandelt. Hierdurch kann das Material oder dessen Oberfläche modifiziert werden (z.B. durch Oxidation, Reduktion, Reinigung, Aufrauen und/oder Vernetzung), wodurch die Oberflächengüte und/oder die (Oberflächen-)Eigenschaften des Bauteils verbesserte werden können. In einer dritten Variante der Behandlung mit dem Plasma wird eine Oberfläche, auf welcher das Material in Schritt b) schichtweise abgelegt wird, vor dem Ablegen in Schritt b) mit dem Plasma behandelt und das Material vor, während und/oder nach dem Ablegen in Schritt b) mit dem Plasma behandelt.

Eine bevorzugte Variante des erfindungsgemäßen Verfahrens zeichnet sich dadurch aus, dass das Plasma in Schritt a) durch eine Gasentladung erzeugt wird, welche vorzugsweise ausgewählt ist aus der Gruppe bestehend aus dielektrisch behinderten Entladungen, Koronaentladungen, Bogenentladungen, durch Mikrowellen angeregte Entladungen, durch Radiofrequenz angeregte Entladungen, und Kombinationen hiervon.

Gemäß einer weiteren bevorzugten Variante weist die Plasmaquelle eine Prozessgaszuleitung und eine Hochspannungselektrode auf, wobei zur Erzeugung des Plasmas in Schritt a) ein durch die Prozessgaszuleitung zugeführtes Prozessgas durch ein von der Hochspannungselektrode erzeugtes elektrisches Feld ionisiert wird. Auf diese Weise ist eine besonders einfache Erzeugung des Plasmas innerhalb der Vorrichtung möglich.

Eine weitere bevorzugte Variante des erfindungsgemäßen Verfahrens ist dadurch gekennzeichnet, dass
- die Plasmaquelle um die Extrusionsdüse herum angeordnet ist, wobei zunächst das Prozessgas über die Prozessgaszuleitung in einen Plasmaerzeugungsbereich der Plasmaquelle geleitet wird, innerhalb welchem das Plasma erzeugt wird, und anschließend das Plasma mit der Oberfläche, auf welcher das Material in Schritt b) schichtweise abgelegt wird, und/oder mit dem Material in Kontakt kommt, wobei es sich bei dem Plasmaerzeugungsbereich vorzugsweise um eine auf einer (äußeren) Oberfläche der Plasmaquelle und um die Extrusionsdüse herum angeordnete Mulde handelt, oder
- die Plasmaquelle in die Extrusionsdüse integriert ist, wobei zunächst das Prozessgas über die Prozessgaszuleitung dem sich in der Extrusionsdüse befindlichen Material zugeführt wird und anschließend innerhalb der Extrusionsdüse das Plasma erzeugt wird, wobei das Plasma vorzugsweise
   - mit dem sich in der Extrusionsdüse befindlichen Material in Kontakt kommt, und/oder
   - durch einen Auslass der Extrusionsdüse entweicht und mit dem bereits abgelegten Material in Kontakt kommt.

Gemäß einer weiteren bevorzugten Variante ist das Prozessgas ausgewählt aus der Gruppe bestehend aus
- Argon, Helium, Sauerstoff, Stickstoff, Wasserstoff, Kohlenstoffdioxid, Luft, Wasserdampf, sowie Mischungen hiervon,
- Mischungen aus Argon und einem oder mehrerer Stoffe ausgewählt aus der Gruppe bestehend aus Hexamethyldisiloxan, Tetramethyldisiloxan, Hexamethylcyclotrisiloxan, Octofluorocyclobutan, sowie Mischungen hiervon,
- Mischungen aus Argon, Wasserstoff und einem Metallsalzaerosol, wobei das Metallsalz vorzugsweise ausgewählt ist aus der Gruppe bestehend aus Goldchlorid, Silberchlorid, Kupferchlorid, sowie Mischungen hiervon, und
- Mischungen hiervon.

Durch die Verwendung verschiedener Prozessgase können unterschiedliche Effekte erzielt werden, insbesondere unterschiedliche Modifikationen des Materials bzw. des hergestellten Bauteils oder von dessen Oberfläche erreicht werden. Beispielsweise kann durch die Verwendung eines sauerstoffhaltigen Prozessgases (z.B. Argon mit Sauerstoff) eine Reinigung der Oberfläche, auf der das Material abgelegt werden soll, von organischen Verunreinigungen (z.B. Klebereste, Haftvermittler, Polymerreste) erzielt werden, indem die im Plasma vorhandenen reaktiven Sauerstoffspezies diese durch oxidative Prozesse entfernen. Auch ist es möglich durch Verwendung reaktiver Prozessgase funktionale Gruppen auf Oberflächen zu erzeugen, welche großen Einfluss auf die Oberflächenenergie und das Adhäsionsverhalten (Verbesserung der Anhaftung von Farben, Lacken und Klebstoffen) hierauf haben. Weiterhin kann beispielsweise durch Verwendung von Argon mit Sauerstoff oder Stickstoff/Luft die Haftung der einzelnen abgelegten Schichten (z.B. Polymerlagen) zueinander und damit die mechanische Stabilität des gesamten hergestellten Bauteils (in z-Richtung) verbessert werden. Durch Verwendung von Mischungen aus Argon und einem oder mehrerer Stoffe ausgewählt aus der Gruppe bestehend aus Hexamethyldisiloxan, Tetramethyldisiloxan, Hexamethylcyclotrisiloxan, Octofluorocyclobutan, sowie Mischungen hiervon, kann eine Abscheidung hydrophober Schichten (während und/oder nach dem Druckprozess) erfolgen. Ferner können Mischungen aus Argon, Wasserstoff und einem Metallsalzaerosol (z.B. Goldchlorid, Silberchlorid, Kupferchlorid) dazu verwendet werden metallische Schichten (während und/oder nach dem Druckprozess) zu erzeugen.

Eine weitere bevorzugte Variante des erfindungsgemäßen Verfahrens ist dadurch gekennzeichnet, dass das Material (welches in Schritt b) geschmolzen wird) ausgewählt ist aus der Gruppe bestehend aus Polymeren, Keramiken, Metallen, sowie Mischungen und Kombinationen hiervon. Bei den Polymeren kann es sich beispielsweise um thermoplastische handeln, die vorzugsweise ausgewählt sind aus der Gruppe bestehend aus Polylactiden (PLA), AcrylnitrilButadien-Styrol-Copolymeren (ABS), Polycarbonaten (PC), Polyethylenterephthalat (PET), Polypropylen (PP), Polyetheretherketonen (PEEK), Polyamiden (PA), sowie Mischungen hiervon.

Gemäß einer weiteren bevorzugten Variante des erfindungsgemäßen Verfahrens wird das Material oder mindestens eine Oberfläche des abgelegten Materials durch die Behandlung des Plasmas modifiziert, wobei das Modifizieren vorzugsweise ausgewählt ist aus der Gruppe bestehend aus Erzeugen funktionaler Gruppen auf mindestens einer Oberfläche des abgelegten Materials, zumindest teilweises Vernetzen des Materials, zumindest teilweises Oxidieren des Materials, zumindest teilweises Reduzieren des Materials, zumindest teilweises Aufrauen einer Oberfläche des abgelegten Materials, zumindest teilweises Reinigen der Oberfläche des abgelegten Materials, sowie Kombinationen hiervon. Die verschiedenen Modifizierungen können beispielsweise durch die Verwendung geeigneter Prozessgase realisiert werden. Ein Vernetzen Oberfläche im Falle der Verwendung eines Polymer-Materials ist beispielsweise durch kurzwellige UV-Strahlung aus der Gasentladung möglich.

Eine weitere bevorzugte Variante des erfindungsgemäßen Verfahrens ist dadurch gekennzeichnet, dass dem Prozessgas und/oder dem erzeugten Plasma mindestens ein Precursorgas zugeführt wird, mit welchem mindestens eine Schicht auf einer Oberfläche, auf welcher das geschmolzene Material in Schritt b) schichtweise abgelegt wird, und/oder auf mindestens einer Oberfläche des abgelegten Materials abgeschieden wird, wobei die Abscheidung vorzugsweise mittels plasmaunterstützter chemischer Gasphasenabscheidung erfolgt. Durch die Verwendung von Precursorgasen können bestimmte Schichten, z.B. Haftvermittlerschichten, auf der Oberfläche der hergestellten Bauteile abgeschieden werden.

Vorzugsweise umfasst dass mindestens eine Precursorgas einen Precursor, der ausgewählt ist aus der Gruppe bestehend aus Aminopropyltrimethoxysilan, Aminopropyltriethoxysilan, Glycidyloxypropyltrimethoxysilan, Mercaptopropyltrimethoxysilan, Isocyanatopropyltrimethoxysilan, Glycidylmethacrylat, Oxazolinen, Maleinsäureanhydrid, sowie Mischungen hiervon. Diese Precursoren sind sehr gut zur Abscheidung von Haftvermittlerschichten geeignet.

Vorzugsweise ist die mindestens eine Schicht ausgewählt aus der Gruppe bestehend aus Haftvermittlerschichten, Dispersionsschichten, Migrationssperrschichten, hydrophoben Schichten, hydrophilen Schichten, sowie Mischungen und Kombinationen hiervon. Möglich ist beispielsweise die Abscheidung von Dispersionsschichten (Verschiedene Partikel eingebettet in Polymermatrix) zur Realisierung verschiedener Funktionen: Selbstheilende Schichten, reversible Haftung, tribologisch wirksamen Mikropartikel (hBN, PTFE), Infrarotstrahlung absorbierende Partikel zur thermischen Nachbehandlung von Polymeroberflächen.

Gemäß einer weiteren bevorzugten Variante des erfindungsgemäßen Verfahrens wird das Verfahren mit einer erfindungsgemäßen Vorrichtung durchgeführt.

Beispielsweise sind folgende Behandlungseffekte durch unterschiedliche Prozessführung und Prozessgase möglich:
1. Reinigung des Drucktisches von organischen Verunreinigungen (Klebereste, Haftvermittler, Polymerreste) vor dem Druckprozess durch ein sauerstoffhaltiges Plasma (z.B. Argon mit Sauerstoff als Prozessgase)
2. Erzeugung von Haftvermittlerschichten auf dem Drucktisch vor dem Druckprozess (z.B. Argon mit beigemischten haftvermittelnden Precursor wie Aminopropyltrimethoxysilan, Aminopropyltriethoxysilan, Glycidyloxypropyltrimethoxysilan, Mercaptopropyltrimethoxysilan, Isocyanatopropyltrimethoxysilan, Glycidylmethacrylat, Oxazoline, Maleinsäureanhydrid)
3. Erzeugung von Haftvermittlerschichten zwischen verschiedenen schlecht aufeinander haftenden Polymeren bei dem Druck von mehrkomponentigen Bauteilen (z.B. Argon mit beigemischten haftvermittelnden Precursor wie Aminopropyltrimethoxysilan, Aminopropy-Itriethoxysilan, Glycidyloxypropyltrimethoxysilan, Mercaptopropyltrimethoxysilan, Isocyanatopropyltrimethoxysilan, Glycidylmethacrylat, Oxazoline, Maleinsäureanhydrid)
4. Erzeugung von Haftvermittlerschichten auf einem fertig gedruckten Bauteil für anschließende Klebe-, Lackier- oder Farbdruckprozesse (z.B. Argon mit beigemischten haftvermittelnden Precursoren wie Aminopropyltrimethoxysilan, Aminopropyltriethoxysilan, Glycidyloxypropyltrimethoxysilan, Mercaptopropyltrimethoxysilan, Isocyanatopropyltrimethoxysilan, Glycidylmethacrylat, Oxazoline, Maleinsäureanhydrid) in einem PECVD-Prozess
5. Erzeugung von Haftvermittlerschichten auf metallischen oder keramischen Oberflächen zur Verbesserung der Anbindungskraft von anschließend aufgedruckten Polymeren
6. Verbesserung der mechanischen Stabilität eines 3D-Gedruckten Bauteils in z-Richtung durch eine Verbesserung der Haftung der Polymerlagen durch eine Plasmabehandlung während des 3D-Druckes eines Polymers (Prozessgas: Argon mit Sauerstoff oder Stickstoff / Luft)
7. Abscheidung von hydrophoben Schichten während und nach Abschluss des 3D-Druckprozesses (Prozessgas: z.B. Argon mit Hexamethyldisiloxan, Tetramethyldisiloxan, Hexamethylcyclotrisiloxan, Octofluorocyclobutan)
8. Abscheidung von metallischen Schichten während und nach Abschluss des 3D-Druckprozesses (Prozessgas: Argon mit Wasserstoff und einem Metallsalzaerosol (bspw. Gold-, Silber- oder Kupferchlorid))
9. Abscheidung von Dispersionsschichten (Verschiedene Partikel eingebettet in Polymermatrix) zur Realisierung verschiedener Funktionen: Selbstheilende Schichten, reversible Haftung, tribologisch wirksamen Mikropartikel (hBN, PTFE), Infrarotstrahlung absorbierende Partikel zur thermischen Nachbehandlung von Polymeroberflächen

Die vorliegende Erfindung wird anhand der nachfolgenden Figuren und Beispiele näher erläutert, ohne die Erfindung auf die speziell dargestellten Parameter zu beschränken.

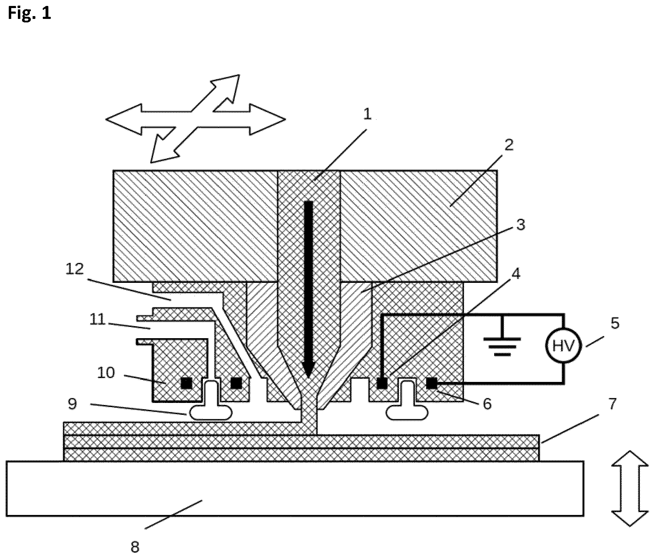

In Fig. 1 ist eine Querschnittsdarstellung einer beispielhaften Ausführungsform der erfindungsgemäßen Vorrichtung zur additiven Fertigung von Bauteilen gezeigt. Die Vorrichtung umfasst einen additiven Fertigungskopf mit einer Extrusionsdüse 3 sowie eine um die Extrusionsdüse 3 herum angeordnete Plasmaquelle 10 zur Erzeugung von Plasma 9. Ferner umfasst die Vorrichtung einen Heizblock 2 zum Schmelzen des Materials 1, eine Prozessgaszuleitung 11, eine Hochspannungselektrode 6, eine geerdete Elektrode 4 und einen Hochspannungsgenerator 5. Die Hochspannungselektrode 6 und die geerdete Elektrode 4 sind kreisförmige Elektroden, zwischen denen ein hohes elektrisches Wechselfeld (Potentialdifferenz > 1kV, > 1 kHz) erzeugt wird. Die Plasmaquelle 10 umfasst eine auf einer äußeren Oberfläche der Plasmaquelle 10 angeordnete und mit der Prozessgaszuleitung 11 verbundene erste Mulde als Plasmaerzeugungsbereich, wobei die erste Mulde und die Hochspannungselektrode 6 um die Extrusionsdüse 3 herum und konzentrisch zueinander angeordnet sind. Die äußere Oberfläche der Plasmaquelle 10, auf welcher die erste Mulde angeordnet ist, weist in dieselbe Richtung wie die Öffnung der Extrusionsdüse 3, durch die das abzulegende Material 1 die Extrusionsdüse verlässt. Ferner umfasst die Plasmaquelle 10 eine Precursorgaszuleitung 12, wobei die Precursorgaszuleitung 12 mit einer zweiten Mulde verbunden ist, die um die Extrusionsdüse 3 herum angeordnet ist. Die zweite Mulde ist auf der gleichen äußeren Oberfläche der Plasmaquelle 10 angeordnet wie die erste Mulde. Die erste und zweite Mulde sind konzentrisch zueinander angeordnet. Zudem hat die zweite Mulde einen geringeren Abstand zur Extrusionsdüse als die erste Mulde. Die erste und die zweite Mulde sind so kreisförmig um die Extrusionsdüse herum angeordnet, dass sich die Extrusionsdüse im Zentrum befindet.

In Fig. 1 wird zudem eine beispielhafte Variante des erfindungsgemäßen Verfahrens gezeigt. Hierbei wird das Material 1, z.B. ein Polymerfilament, mithilfe des Heizblocks 2 geschmolzen, durch die Extrusionsdüse 3 gepresst und schichtweise auf einem Drucktisch 8 abgelegt. Über die Prozessgaszuleitung 11 wird ein Prozessgas in den Plasmaerzeugungsbereich bzw. die erste Mulde geleitet. Dort wird das Prozessgas durch ein von der Hochspannungselektrode 6 erzeugtes elektrisches Feld bzw. eine Gasentladung ionisiert, wodurch das Plasma 9 erzeugt wird. Das Plasma 9 entweicht aus der Mulde und kommt mit dem bereits abgelegten Material 7 in Kontakt, sodass das abgelegte Material 7 bzw. dessen Oberfläche mit dem Plasma modifiziert werden kann. Über die Precursorgaszuleitung 12 kann zusätzlich ein Precursorgas zugeführt werden, dass in die zweite Mulde geleitet wird und von dort entweichen und mit dem Plasma sowie dem bereits abgelegten Material 7 in Kontakte kommen kann. Auf diese Weise kann je nach verwendetem Precursorgas eine spezielle Beschichtung auf dem abgelegten Material 7 bzw. dessen Oberfläche erhalten werden.

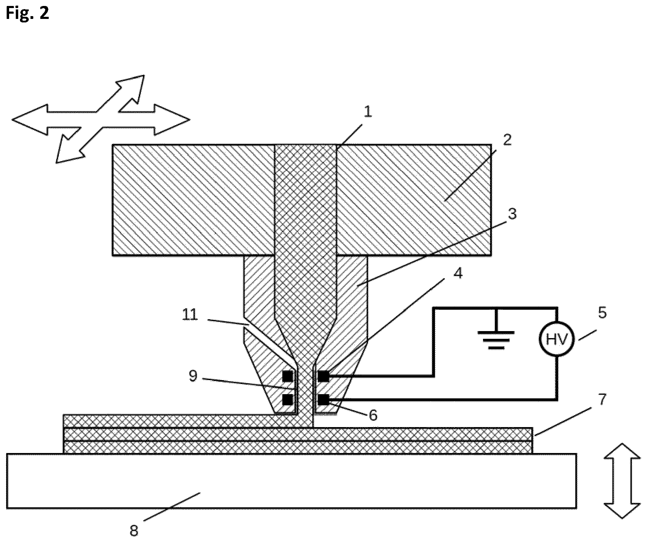

In Fig. 2 ist eine Querschnittsdarstellung einer nicht durch die Ansprüche abgedeckten Vorrichtung zur additiven Fertigung von Bauteilen gezeigt. Die Vorrichtung umfasst ebenfalls einen additiven Fertigungskopf mit einer Extrusionsdüse 3. Im Gegensatz zur in Fig. 1 gezeigten Ausführungsform ist die Plasmaquelle zur Erzeugung des Plasmas hier jedoch in die Extrusionsdüse 3 integriert. Ferner umfasst die Vorrichtung einen Heizblock 2 zum Schmelzen des Materials 1, eine Prozessgaszuleitung 11, eine Hochspannungselektrode 6, eine geerdete Elektrode 4 und einen Hochspannungsgenerator 5. Die Hochspannungselektrode 6 und die geerdete Elektrode 4 sind kreisförmige Elektroden, zwischen denen ein hohes elektrisches Wechselfeld (Potentialdifferenz > 1kV, > 1 kHz) erzeugt wird. Die Prozessgaszuleitung 11 ist mit einem Kanal der Extrusionsdüse 3 zum Hindurchpressen des geschmolzenen abzulegenden Materials 1 verbunden. Dieser Kanal weist einen Plasmaerzeugungsbereich auf, um den herum die Hochspannungselektrode 6 angeordnet ist. Die Verbindung zwischen der Prozessgaszuleitung 11 und dem Kanal der Extrusionsdüse 3 befindet sich hierbei (in Pressrichtung des Materials) knapp vor dem Plasmaerzeugungsbereich.

Das Material 1, z.B. ein Polymerfilament, wird mithilfe des Heizblocks 2 geschmolzen, durch die Extrusionsdüse 3 gepresst und schichtweise auf einem Drucktisch 8 abgelegt. Im Gegensatz zur Vorrichtung in Fig. 1 wird hier jedoch das über die Prozessgaszuleitung 11 zugeführte Prozessgas in den Kanal der Extrusionsdüse 3 geleitet, wo es in den dort befindlichen Plasmaerzeugungsbereich gelangt. Dort wird das Prozessgas durch ein von der Hochspannungselektrode 6 erzeugtes elektrisches Feld bzw. eine Gasentladung ionisiert, wodurch das Plasma 9 erzeugt wird. Das kommt dann direkt mit dem noch nicht abgelegten Material 1 in Kontakt. Zudem kann das Plasma 9 durch den Auslass der Extrusionsdüse entweichen und kommt dort auch mit dem bereits abgelegten Material 7 in Kontakt. Auf diese Weise kann das abgelegte Material 7 bzw. dessen Oberfläche mit dem Plasma modifiziert werden.

## Patentansprüche

1. Vorrichtung zur additiven Fertigung von Bauteilen, umfassend einen additiven Fertigungskopf mit einer Extrusionsdüse (3) sowie eine um die Extrusionsdüse (3) herum angeordnete oder in die Extrusionsdüse (3) integrierte Plasmaquelle (10) zur Erzeugung von Plasma (9), **dadurch gekennzeichnet, dass** die Plasmaquelle (10) eine Precursorgaszuleitung (12) umfasst, wobei die Precursorgaszuleitung (12) mit einer auf einer Oberfläche der Plasmaquelle (10) angeordneten Mulde verbunden ist, die um die Extrusionsdüse (3) herum angeordnet ist.

2. Vorrichtung gemäß dem vorhergehenden Anspruch, **dadurch gekennzeichnet, dass** die Plasmaquelle (10) eine Prozessgaszuleitung (11) und eine Hochspannungselektrode (6) umfasst.

3. Vorrichtung gemäß dem vorhergehenden Anspruch, **dadurch gekennzeichnet, dass** die Plasmaquelle (10) um die Extrusionsdüse (3) herum angeordnet ist und eine auf einer Oberfläche der Plasmaquelle (10) angeordnete und mit der Prozessgaszuleitung (11) verbundene Mulde als Plasmaerzeugungsbereich umfasst, wobei die Mulde und die Hochspannungselektrode (6) um die Extrusionsdüse (3) herum und konzentrisch zueinander angeordnet sind.

4. Vorrichtung gemäß Anspruch 2, **dadurch gekennzeichnet, dass** die Plasmaquelle in die Extrusionsdüse (10) integriert ist, wobei die Prozessgaszuleitung (11) mit einem Kanal der Extrusionsdüse (3) zum Hindurchpressen von geschmolzenem Material verbunden ist, wobei die Hochspannungselektrode (6) um einen Plasmaerzeugungsbereich des Kanals der Extrusionsdüse (3) herum angeordnet ist, und wobei sich die Verbindung zwischen der Prozessgaszuleitung (11) und dem Kanal der Extrusionsdüse (3) in dem Plasmaerzeugungsbereich und/oder in Pressrichtung des Materials vor dem Plasmaerzeugungsbereich befindet.

5. Verfahren zur additiven Fertigung von Bauteilen, bei welchem
a) mithilfe einer um eine Extrusionsdüse (3) eines additiven Fertigungskopfes herum angeordneten oder in die Extrusionsdüse (3) integrierten Plasmaquelle (10) ein Plasma (9) erzeugt wird, wobei die Plasmaquelle (10) eine Precursorgaszuleitung (12) umfasst, wobei die Precursorgaszuleitung (12) mit einer auf einer Oberfläche der Plasmaquelle (10) angeordneten Mulde verbunden ist, die um die Extrusionsdüse (3) herum angeordnet ist,
b) ein Material geschmolzen, durch die Extrusionsdüse (3) gepresst und schichtweise abgelegt wird, und
c) eine Behandlung mit dem Plasma (9) erfolgt, bei welcher
- eine Oberfläche, auf welcher das Material in Schritt b) schichtweise abgelegt wird, vor dem Ablegen in Schritt b) mit dem Plasma (9) behandelt wird, und/oder
- das Material vor, während und/oder nach dem Ablegen in Schritt b) mit dem Plasma (9) behandelt wird.

6. Verfahren gemäß Anspruch 5, **dadurch gekennzeichnet, dass** das Plasma (9) in Schritt a) durch eine Gasentladung erzeugt wird, welche vorzugsweise ausgewählt ist aus der Gruppe bestehend aus dielektrisch behinderten Entladungen, Koronaentladungen, Bogenentladungen, durch Mikrowellen angeregte Entladungen, durch Radiofrequenz angeregte Entladungen, und Kombinationen hiervon.

7. Verfahren gemäß Anspruch 5 oder 6, **dadurch gekennzeichnet, dass** die Plasmaquelle (10) eine Prozessgaszuleitung (11) und eine Hochspannungselektrode (6) aufweist, wobei zur Erzeugung des Plasmas (9) in Schritt a) ein durch die Prozessgaszuleitung (11) zugeführtes Prozessgas durch ein von der Hochspannungselektrode (6) erzeugtes elektrisches Feld ionisiert wird.

8. Verfahren gemäß Anspruch 7, **dadurch gekennzeichnet, dass**
- die Plasmaquelle (10) um die Extrusionsdüse (3) herum angeordnet ist, wobei zunächst das Prozessgas über die Prozessgaszuleitung (11) in einen Plasmaerzeugungsbereich der Plasmaquelle (10) geleitet wird, innerhalb welchem das Plasma (9) erzeugt wird, und anschließend das Plasma (9) mit der Oberfläche, auf welcher das Material in Schritt b) schichtweise abgelegt wird, und/oder mit dem Material in Kontakt kommt, wobei es sich bei dem Plasmaerzeugungsbereich vorzugsweise um eine auf einer äußeren Oberfläche der Plasmaquelle (9) und um die Extrusionsdüse (3) herum angeordnete Mulde handelt, oder
- die Plasmaquelle (9) in die Extrusionsdüse (3) integriert ist, wobei zunächst das Prozessgas über die Prozessgaszuleitung (11) dem sich in der Extrusionsdüse (3) befindlichen Material zugeführt wird und anschließend innerhalb der Extrusionsdüse (3) das Plasma (9) erzeugt wird.

9. Verfahren gemäß einem der Ansprüche 5 bis 8, **dadurch gekennzeichnet, dass** das Prozessgas ausgewählt ist aus der Gruppe bestehend aus
- Argon, Helium, Sauerstoff, Stickstoff, Wasserstoff, Kohlenstoffdioxid, Luft, Wasserdampf, sowie Mischungen hiervon,
- Mischungen aus Argon und einem oder mehrerer Stoffe ausgewählt aus der Gruppe bestehend aus Hexamethyldisiloxan, Tetramethyldisiloxan, Hexamethylcyclotrisiloxan, Octofluorocyclobutan, sowie Mischungen hiervon,
- Mischungen aus Argon, Wasserstoff und einem Metallsalzaerosol, wobei das Metallsalz vorzugsweise ausgewählt ist aus der Gruppe bestehend aus Goldchlorid, Silberchlorid, Kupferchlorid, sowie Mischungen hiervon, und
- Mischungen hiervon.

10. Verfahren gemäß einem der Ansprüche 5 bis 9, **dadurch gekennzeichnet, dass** das Material ausgewählt ist aus der Gruppe bestehend aus Polymeren, Keramiken, Metallen, sowie Mischungen und Kombinationen hiervon.

11. Verfahren gemäß einem der Ansprüche 5 bis 10, **dadurch gekennzeichnet, dass** das Material oder mindestens eine Oberfläche des abgelegten Materials durch die Behandlung des Plasmas (9) modifiziert wird, wobei das Modifizieren vorzugsweise ausgewählt ist aus der Gruppe bestehend aus Erzeugen funktionaler Gruppen auf mindestens einer Oberfläche des abgelegten Materials, zumindest teilweises Vernetzen des Materials, zumindest teilweises Oxidieren des Materials, zumindest teilweises Reduzieren des Materials, zumindest teilweises Aufrauen einer Oberfläche des abgelegten Materials, zumindest teilweises Reinigen der Oberfläche des abgelegten Materials, sowie Kombinationen hiervon.

12. Verfahren gemäß einem der Ansprüche 5 bis 11, **dadurch gekennzeichnet, dass** dem Prozessgas und/oder dem erzeugten Plasma mindestens ein Precursorgas zugeführt wird, mit welchem mindestens eine Schicht auf einer Oberfläche, auf welcher das geschmolzene Material in Schritt b) schichtweise abgelegt wird, und/oder auf mindestens einer Oberfläche des abgelegten Materials abgeschieden wird, wobei die Abscheidung vorzugsweise mittels plasmaunterstützter chemischer Gasphasenabscheidung erfolgt.

13. Verfahren gemäß Anspruch 12, **dadurch gekennzeichnet, dass**
- das mindestens eine Precursorgas einen Precursor umfasst, der ausgewählt ist aus der Gruppe bestehend aus Aminopropyltrimethoxysilan, Aminopropyltriethoxysilan, Glycidyloxypropyltrimethoxysilan, Mercaptopropyltrimethoxysilan, Isocyanatopropyltrimethoxysilan, Glycidylmethacrylat, Oxazolinen, Maleinsäureanhydrid, sowie Mischungen hiervon, und/oder
- die mindestens eine Schicht ausgewählt ist aus der Gruppe bestehend aus Haftvermittlerschichten, Dispersionsschichten, Migrationssperrschichten, hydrophoben Schichten, hydrophilen Schichten, sowie Mischungen und Kombinationen hiervon.

14. Verfahren gemäß einem der Ansprüche 5 bis 13, **dadurch gekennzeichnet, dass** das Verfahren mit einer Vorrichtung nach einem der Ansprüche 1 bis 4 durchgeführt wird.

## Claims

1. Apparatus for the additive manufacturing of components, comprising an additive manufacturing head with an extrusion nozzle (3) and a plasma source (10) for producing plasma (9) arranged around the extrusion nozzle (3) or integrated in the extrusion nozzle (3), **characterized in that** the plasma source (10) comprises a precursor gas feed line (12), the precursor gas feed line (12) being connected to a depression arranged on a surface of the plasma source (10), which depression is arranged around the extrusion nozzle (3).

2. Apparatus in accordance with the preceding claim, **characterized in that** the plasma source (10) comprises a process gas feed line (11) and a high voltage electrode (6).

3. Apparatus in accordance with the preceding claim, **characterized in that** the plasma source (10) is arranged around the extrusion nozzle (3) and comprises a depression arranged on a surface of the plasma source (10) and connected to the process gas feed line (11) as a plasma production region, with the depression and the high voltage electrode (6) being arranged around the extrusion nozzle (3) and concentrically with one another.

4. Apparatus in accordance with claim 2, **characterized in that** the plasma source is integrated into the extrusion nozzle (10), with the process gas feed line (11) being connected to a passage of the extrusion nozzle (3) for pressing through melted material, with the high voltage electrode (6) being arranged around a plasma production region of the passage of the extrusion nozzle (3) and with the connection between the process gas feed line (11) and the passage of the extrusion nozzle (3) being located in the plasma production region and/or in the pressing direction of the material before the plasma production region.

5. Method for the additive manufacturing of components in which
a) a plasma (9) is produced with the aid of a plasma source (10) arranged around an extrusion nozzle (3) of an additive manufacturing head or integrated into the extrusion nozzle (3), the plasma source (10) comprising a precursor gas feed line (12), the precursor gas feed line (12) being connected to a depression arranged on a surface of the plasma source (10), which depression is arranged around the extrusion nozzle (3),
b) a material is melted, pressed through the extrusion nozzle (3), and deposited in layers, and
c) a treatment with the plasma (9) takes place, in which
- a surface on which the material is deposited in layers in step b) is treated with the plasma (9) before the deposition in step b); and/or
- the material is treated with the plasma (9) before, during, and/or after the deposition in step b).

6. Method in accordance with claim 5, **characterized in that** the plasma (9) is produced by a gas discharge in step a) that is preferably selected from the group consisting of dielectrically hindered discharges, corona discharges, arc discharges, discharges excited by microwaves, discharges excited by radio frequency, and combinations thereof.

7. Method in accordance with claim 5 or claim 6, **characterized in that** the plasma source (10) has a process gas feed line (11) and a high voltage electrode (6), with a process gas supplied by the process gas feed line (11) being ionized by an electrical field produced by the high voltage electrode (6) to produce the plasma (9) in step a).

8. Method according to claim 7, **characterized in that**
- the plasma source (10) is arranged around the extrusion nozzle (3), with the process gas first being conducted via the process gas feed line (11) into a plasma production region of the plasma source (10) within which the plasma (9) is produced, and with the plasma (9) subsequently coming into contact with the surface on which the material is deposited in layers in step b) and/or with the material, with the plasma production region preferably being a depression arranged on an outer surface of the plasma source (9) and around the extrusion nozzle (3), or
- the plasma source (9) is integrated into the extrusion nozzle (3), with the process gas first being supplied via the process gas feed line (11) to the material present in the extrusion nozzle (3) and with the plasma (9) subsequently being produced within the extrusion nozzle (3).

9. Method in accordance with one of the claims 5 to 8, **characterized in that** the process gas is selected from the group consisting of
- argon, helium, oxygen, nitrogen, hydrogen, carbon dioxide, air, water vapor, and mixtures thereof,
- mixtures of argon and one or more substances selected from the group consisting of hexamethyldisiloxane, tetramethyldisiloxane hexamethylcyclotrisiloxane, octofluorocyclobutane, and mixtures thereof,
- mixtures of argon, hydrogen, and a metal salt aerosol, with the metal salt preferably being selected from the group consisting of gold chloride, silver chloride, copper chloride, and mixtures thereof, and
- mixtures thereof.

10. Method in accordance with one of the claims 5 to 9, **characterized in that** the material is selected from the group consisting of polymers, ceramic materials, metals, and mixtures and combinations thereof.

11. Method in accordance with one of the claims 5 to 10, **characterized in that** the material or at least one surface of the deposited material is modified by the treatment of the plasma (9), with the modification preferably being selected from the group consisting of a production of functional groups on at least one surface of the deposited material, an at least partial crosslinking of the material, an at least partial oxidation of the material, an at least partial reduction of the material, an at least partial roughening of a surface of the deposited material, an at least partial cleaning of the surface of the deposited material, and combinations thereof.

12. Method in accordance with one of the claims 5 to 11, **characterized in that** at least one precursor gas is supplied to the process gas and/or to the generated plasma, by which precursor gas at least one layer is deposited on a surface on which the melted material is deposited in layers in step b) and/or on at least one surface of the deposited material, with the deposition preferably taking place by means of plasma-enhanced chemical vapor deposition.

13. Method in accordance with claim 12, **characterized in that**
- the at least one precursor gas comprises a precursor that is selected from the group consisting of aminopropyltrimethoxysilane, aminopropyltriethoxysilane, glycidyloxypropyltri-methoxysilane, mercaptopropyltrimethoxysilane, isocyanatopropyltrimethoxysilane, glycidylmethacrylate, oxazolines, maleic acid anhydride, and mixtures thereof, and/or
- the at least one layer is selected from the group consisting of adhesion promoter layers, dispersion layers, migration barrier layers, hydrophobic layers, hydrophilic layers, and mixtures and combinations thereof.

14. Method in accordance with one of the claims 5 to 13, **characterized in that** the method is carried out using an apparatus according to any one of the claims 1 to 4.

## Revendications

1. Dispositif pour la fabrication additive de pièces, comprenant une tête de fabrication additive avec une buse d'extrusion (3) ainsi qu'une source de plasma (10) disposée autour de la buse d'extrusion (3) ou intégrée dans la buse d'extrusion (3), pour la production de plasma (9), **caractérisé en ce que** la source de plasma (10) comprend une conduite d'alimentation en gaz précurseur (12), dans lequel la conduite d'alimentation en gaz précurseur (12) est relié avec une cavité disposée sur une surface de la source de plasma (10), qui est disposée autour de la buse d'extrusion (3).

2. Dispositif selon la revendication précédente, **caractérisé en ce que** la source de plasma (10) comprend une conduite d'alimentation en gaz de process (11) et une électrode à haute tension (6).

3. Dispositif selon la revendication précédente, **caractérisé en ce que** la source de plasma (10) est disposée autour de la buse d'extrusion (3) et comprend, en tant que zone de production de plasma, une cavité disposée sur une surface de la source de plasma (10) et reliée avec la conduite d'alimentation en gaz de process (11), dans lequel la cavité et l'électrode à haute tension (6) sont disposées autour de la buse d'extrusion (3) et de façon concentrique entre elles.

4. Dispositif selon la revendication 2, **caractérisé en ce que** la source de plasma est intégrée dans la buse d'extrusion (10), dans lequel la conduite d'alimentation en gaz de process (11) est reliée avec un canal de la buse d'extrusion (3) pour la compression d'un matériau en fusion à travers celui-ci, dans lequel l'électrode à haute tension (6) est disposée autour d'une zone de production de plasma du canal de la buse d'extrusion (3), et dans lequel la liaison entre la conduite d'alimentation en gaz de process (11) et le canal de la buse d'extrusion (3) se trouve dans la zone production de plasma et/ou, dans le sens de compression du matériau, avant la zone de production de plasma.

5. Procédé pour la fabrication additive de pièces, dans lequel
a) à l'aide d'une source de plasma (10) disposée autour d'une buse d'extrusion (3) d'une tête de fabrication additive ou intégrée dans la buse d'extrusion (3), un plasma (9) est produit, dans lequel la source de plasma (10) comprend une conduite d'alimentation en gaz précurseur (12), dans lequel la conduite d'alimentation en gaz précurseur (12) est reliée avec une cavité disposée sur une surface de la source de plasma (10), qui est disposée autour de la buse d'extrusion (3),
b) un matériau est fondu, comprimé par la buse d'extrusion (3) et déposé par couches et
c) un traitement avec le plasma (9) a lieu, dans lequel
- une surface sur laquelle le matériau est déposé par couches à l'étape b) est traité, avant le dépôt à l'étape b), avec le plasma (9) et/ou
- le matériau est traité avant, pendant et/ou après le dépôt à l'étape b), avec le plasma (9).

6. Procédé selon la revendication 5, **caractérisé en ce que** le plasma (9) est produit, à l'étape a), par une décharge de gaz, qui est sélectionnée de préférence dans le groupe constitué de décharges à barrières diélectriques, de décharges corona, de décharges en arc, de décharges provoquées par des micro-ondes, de décharges provoquées par une fréquence radio et des combinaisons de celles-ci.

7. Procédé selon la revendication 5 ou 6, **caractérisé en ce que** la source de plasma (10) comprend une conduite d'alimentation en gaz de process (11) et une électrode à haute tension (6), dans lequel, pour la production du plasma (9) à l'étape a), un gaz de process introduit grâce à la conduite d'alimentation en gaz de process (11) est ionisé par un champ électrique généré par l'électrode à haute tension (6).

8. Procédé selon la revendication 7, **caractérisé en ce que**
- la source de plasma (10) est disposée autour de la buse d'extrusion (3), dans lequel le gaz de process est d'abord guidé par la conduite d'alimentation en gaz de process (11) vers une zone de production de plasma de la source de plasma (10), à l'intérieur de laquelle le plasma (9) est produit, puis le plasma (9) entre en contact avec la surface sur laquelle le matériau est déposé par couches à l'étape b) et/ou avec le matériau, dans lequel la zone de production de plasma est de préférence une cavité disposée sur une surface externe de la source de plasma (9) et autour de la buse d'extrusion (3) ou
- la source de plasma (9) est intégrée dans la buse d'extrusion (3), dans lequel le gaz de process est d'abord amené, par l'intermédiaire de la conduite de gaz de process (11), vers le matériau se trouvant dans la buse d'extrusion (3) et le plasma (9) est ensuite produit à l'intérieur de la buse d'extrusion (3).

9. Procédé selon l'une des revendications 5 à 8, **caractérisé en ce que** le gaz de process est sélectionné dans le groupe constitué de
- argon, hélium, oxygène, azote, hydrogène, dioxyde de carbone, air, vapeur d'eau ainsi que des mélanges de ceux-ci,
- mélanges d'argon et d'un ou plusieurs composés sélectionnés dans le groupe constitué de l'hexaméthyldisiloxane, du tétra-méthyldisiloxane, de l'hexaméthylcyclotrisiloxane, de l'octofluorocyclobutane, ainsi que des mélanges de ceux-ci,
- mélanges d'argon, d'hydrogène et d'un aérosol de sel métallique, dans lequel le sel métallique est sélectionné de préférence dans le groupe constitué du chlorure d'or, du chlorure d'argent, du chlorure de cuivre, ainsi que de mélanges de ceux-ci et
- des mélanges de ceux-ci.

10. Procédé selon l'une des revendications 5 à 9, **caractérisé en ce que** le matériau est sélectionné dans le groupe constitué de polymères, de céramiques, de métaux, ainsi que des mélanges et combinaisons de ceux-ci.

11. Procédé selon l'une des revendications 5 à 10, **caractérisé en ce que** le matériau ou au moins une surface du matériau déposé est modifié par le traitement du plasma (9), dans lequel la modification est sélectionnée de préférence dans le groupe constitué de la production de groupe fonctionnels sur au moins une surface du matériau déposé, réticulation au moins partielle du matériau, oxydation au moins partielle du matériau, réduction au moins partielle du matériau, abrasion au moins partielle d'une surface du matériau déposé, nettoyage au moins partiel de la surface du matériau déposé, ainsi que des combinaisons de celles-ci.

12. Procédé selon l'une des revendications 5 à 11, **caractérisé en ce que**, au gaz de process et/ou au plasma produit est ajouté au moins un gaz précurseur avec lequel au moins une couche est déposée sur une surface sur laquelle le matériau en fusion est déposé par couches à l'étape b) et/ou sur au moins une surface du matériau déposé, dans le-quelle dépôt a lieu de préférence au moyen d'un dépôt chimique en phase gazeuse favorisé par le plasma.

13. Procédé selon la revendication 12, **caractérisé en ce que**
- l'au moins un gaz précurseur comprend un précurseur qui est sélectionné dans le groupe constitué de l'aminopropyltrimé-thoxysilane, de l'aminopropyltriéthoxysilane du glucidyloxypro-pyltriméthoxysilane, du mercaptopropyltriméthoxysilane, de l'isocyanatopropyltriméthoxysilane, du glucidylméthacrylate, d'oxazolines, de l'anhydride d'acide malique, ainsi que des mélanges de ceux-ci et/ou
- l'au moins une couche est sélectionnée dans le groupe constitué de couches de promoteurs d'adhérence, de couches de dispersion, de couches barrières anti-migration, de couches hydrophobes, de couches hydrophiles, ainsi que des mélanges et combinaisons de celles-ci.

14. Procédé selon l'une des revendications 5 à 13, **caractérisé en ce que** le procédé est exécuté avec un dispositif selon l'une des revendications 1 à 4.
